(19) Europäisches Patentamt

European Patent Office

Office européen des brevets

(11) **EP 1 031 994 B1**

## (12) EUROPEAN PATENT SPECIFICATION

(45) Date of publication and mention
of the grant of the patent:
**24.07.2002   Bulletin 2002/30**

(51) Int Cl.7: **G11C 29/00**

(21) Application number: **99103478.6**

(22) Date of filing: **23.02.1999**

(54) **Built-in self-test circuit for memory**

Speicherschaltungen mit eingebautem Selbsttest

Circuits de mémoire à auto-test incorporés

(84) Designated Contracting States:
**DE FR GB NL**

(43) Date of publication of application:
**30.08.2000   Bulletin 2000/35**

(73) Proprietor: **Taiwan Semiconductor
Manufacturing Co., Ltd.
Hsin-Chu 300 (TW)**

(72) Inventors:
 • **Huang, Shi-Yu
   Hsinchu, TW (TW)**

 • **Kwai, Ding-Ming
   Hsinchu, TW (TW)**

(74) Representative: **Viering, Jentschura & Partner
Postfach 22 14 43
80504 München (DE)**

(56) References cited:
**EP-A- 0 805 460          US-A- 3 831 148**

**Description**

BACKGROUND OF THE INVENTION

Field of the Invention

The invention relates to a test and a test hardware of a memory. More particularly, the invention relates to a built-in self-test circuit for memories embedded on the same chip.

Description of the Related Art

Memories are susceptible to fabrication process related failures caused by dust particles on the chips or masks, scratches and gate oxide pinholes, which may result open or short circuits. Many methods or hardwares have been developed to test whether a memory can function normally. However, as the integrated circuit art becomes more and more advanced, functions of memories become much more and more complex. Consequently, it often takes a great time and requires a complex circuit to perform a functional test of the memories.

Techniques of built-in self-test (BIST) for memories have been developed to resolve the above problems. In the built-in self-test technique for memory, a test algorithm is translated into a sequence of commands, data, and addresses applied to the memory under test. Traditionally, a hard-wired finite state machine (FSM) is used to implement the translation process. To provide the capability of at-speed testing, the BIST circuit operates as fast as the memory under test. A disadvantage of the approach is that the finite state machine is tailored to a specific set of test patterns whose complexity depends on the test algorithm. As the complexity of the test algorithm increases, this approach may be inadequate because the finite state machine may become too large and too slow to produce a test pattern in each clock cycle to intensively exercise the memory under test.

Some BIST circuits, known to be the programmable or configurable BIST circuits, can be referred to U.S. Patent No. 5,173,906, "Built-in Self-Test for Integrated Circuit" disclosed by Dreibelbis et al, in 1992. Another disclosure of a circuit that uses a micro-coded sequence defined in the contents of a read-only memory to produce the test patterns is issued with a US Patent No. 5,224,101 to Popyack et al in 1993. In US Patent No. 5,301,156, "Configurable Self-Test for Embedded RAMs", Talley et al discloses a circuit that has a serial path which passes through the address, command, and data portions of the circuit to shift in a test or control patterns and to shift out the results, each scan requiring several clock cycles.

The test algorithm for a dynamic random access memory (DRAM) is typically complex and requires a relatively long period of time to perform the test. In the above-mentioned prior art, none of them has disclosed a method nor a structure specially applicable in a DRAM to resolve the problem of testing speed.

SUMMARY OF THE INVENTION

The invention provides a circuit for memory testing, especially for a DRAM. The circuit comprises two finite state machines, so as to adapt the pipeline technique. In addition, a certain protocol on communicating these two finite machines is established. The timing criticality of the design is further relaxed.

The invention provides a built-in self-test circuit for testing a memory embedded on the same chip, especially for testing a DRAM. The built-in circuit comprises two finite state machines, a queue, an encoder, a memory input buffer, a delay buffer, and a comparator in a pipeline structure.

One of the finite state machines is called a producer which translates a test algorithm into a sequence of macro-instructions. The other finite state machine is called a scheduler which further interprets each of these macro-instructions into a series of test patterns. The queue is connected between the producer and the scheduler serving as a synchronization buffer, so that an operation of "latch-and-shift forward" is performed. The test patterns are then input from the scheduler to the encoder which encodes the test patterns from one-hot code into a binary code defined by the memory. The pipeline thus comprises three stages, the first stage translates the test algorithm into the macro-instructions, the second stage interprets the macro-instructions into the test patterns, and the third stage encodes the one-hot code into the memory defined binary code. Due to the potential performance degradation of the memory device introduced by the BIST circuit, the encoder is further connected to a BIST output buffer (BOB).

The delay buffer is connected between the BIST output buffer and the comparator. An expected response of memory is computed thereby.

The delay buffer outputs the computed result of the expected response to the comparator. The comparator then compares the expected response with the memory test response to determine whether the memory fails or passes.

The invention further provides a method for testing a memory, especially for testing a DRAM. A test algorithm is input and translated by a first finite machine into a sequence of macro-instructions. Being synchronized by a queue according to a communication protocol, each of the macro-instructions is interpreted into a sequence of one-hot encoded test patterns. Each of the one-hot encoded test patterns is then mapped to a code defined by the DRAM. Via the BIST delay buffer, the mapped codes are fed into the DRAM to perform a test. As shown in the figure, a multiplexer (MUX) is further installed between the BIST circuit and the DRAM. The test results of both the output response of the DRAM and an expected memory response are input to the comparator The comparator compares the output response of the DRAM with the expected memory response While the test response of the memory appears the same as the expected response, the BIST circuit displays a "pass" information. On the contrary, if the test response of the memory is different from the expected response, the BIST circuit indicates a fail information.

It is to be understood that both the foregoing general description and the following detailed description are for exemplary and explanatory only and are not restrictive of the invention, as claimed.

BRIEF DESCRIPTION OF THE DRAWINGS

Figure 1 shows a state transition graph of march algorithm in the first finite machine;

Figure 2(a) shows a state transition graph for the second finite machine, wherein each node is a sub-machine;

Figure 2(b) shows the sub-machines for macro-instructions of READ_A_ROW, WRITE_A_ROW, and RWR_A_ROW;

Figure 3 is a block diagram of a built-in self-test circuit according to a preferred embodiment of the invention; and

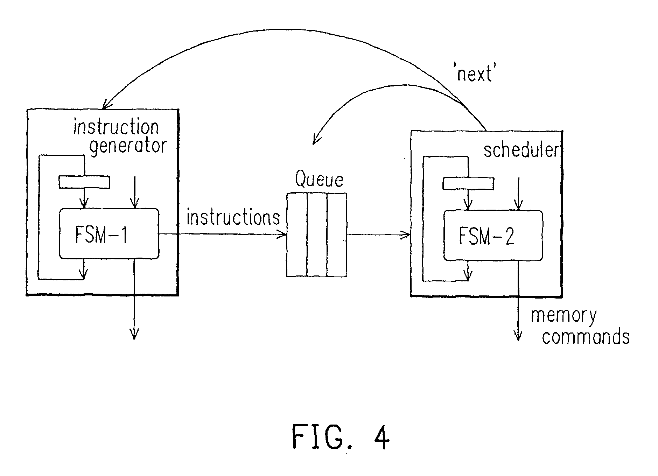

Figure 4 shows a synchronization mechanism between the first and the second finite machines.

DESCRIPTION OF THE PREFERRED EMBODIMENTS

The Test Algorithm

While performing a test on a memory device, a test algorithm written as a program in a high-level language is often proposed. Considering a DRAM comprising $R$ rows and $C'$ columns is to be tested, four steps are included in a march algorithm. In a first step, '0' is written to every cell. The second step walks through the entire array in a forward manner, that is, from the first cell in the first row to the last cell in the last row. At each cell, a so-called READ(0)-WRITE (1)-READ(1) operation is performed. This READ-WRITE-READ operation is proposed in an attempt to better expose the potential dynamic defects of the memory cells. The third step walks through the entire cell from the last cell to the first cell. At each cell, a READ(1)-WRITE(0)-READ(0) operation is performed. The fourth step of this algorithm checks if the value of every cell is still zero after the first three steps.

An example of this march algorithm programmed in a high-level language is as presented herewith.

```
{

/*--- step 1: write 0 to each cell ---*/

foreach_row(i=0; i<R; i++){

        foreach_col(j=0; j<C; j++){Write 0 to cell(i, j)}

    }

/*--- step 2: change each cell from 0 to 1 in a forward manner ---*/

foreach_row(i=0; i<R; i++){

        foreach_col(j=0; j<C:

        Read 0 from cell(i, j)

        Write 1 to cell(i, j);
```

4

**Read** 1 from cell(i, j)

```
            }

/*--- step 3: change each cell from 1 to 0 in a backward manner ---*/

foreach_row(i=R-1; i>=0; I--){

    foreach_col(j=(C-1); j>0; j--

        Read 1 from cell(i, j)

        Write 0 to cell(i, j);

        Read 0 from cell(i, j)

    • }

/*--- step 4: read 0 to each cell ---*/

foreach_row(i=0; i<R; i++){

    foreach_col(j=0; j<C; j++){Read 0 to cell(i, j)}

        }
    }

}
```

The Macro-Instructions

In this invention, a pipeline comprising three stages for translating the high-level algorithm into test patterns for a memory device to be tested by a BIST circuit is disclosed. The algorithm is first translated into a sequence of macro-instructions in the first stage, followed by further interpreting each of the macro-instructions into a sequence of test patterns in the second stage. The one-hot codes of the test patterns are then encoded into a binary code defined by the memory device.

In this embodiment, a DRAM is taken as an example to be tested. To test a DRAM, a basic activity often comprises at least one of the memory commands {*mem_nop, mem_active, mem_read, mem_write*, *mem_precharge*, *mem_refresh*} defined by the DRAM, where

*mem_nop* performs no operation.

*mem_active* activates the wordline of a row.

*mem_read* issues a memory read command.

*mem_precharge* bring voltages of columns to a precharge level

The entire sequence of memory commands needed to complete a read/write cycle from a specific cell to another specific cell is called an operation, denoted as READ/WRITE. For example, a READ operation to a memory cell may be composed of the sequence of {*mem_active→mem_nop→mem_read→mem_read→mem_nop→mem_precharge*}. Apart from the above memory commands, a test pattern further comprises data value, row address, and column address.

The macro-instructions are expressed by four-tuples (opcode, data, row-address, column-address), where data, row address, and column address could be "Don't care" represented by "*". Seven types of macro-instructions are used in the design:

(NOP, *, *, *) corresponds to the test pattern (*mem_nop*, *, *, *).

(READ, *v*, *r*, *c*) reads an expected value *v* from the cell with row address *r* and column address *c*. This macro-instruction corresponds to a basic read cycle.

(WRITE. *v*, *r*, *c*) writes an expected value *v* from the cell with row address *r* and column address *c*. This macro-instruction corresponds to a basic write cycle.

(READ_A_ROW. *v*, *r*, *) reads an expected value *v* from every cell in a row *r* sequentially.

(WRITE_A_ROW, *v*, *r*, *) writes a binary value *v* from every cell in a row *r* sequentially.

(RWR_A_ROW, *v*, *r*, *) performs the READ-WRITE-READ operation to every cell in row *r* sequentially. The three data values for the operation depends on the value of *v*, If *v* is 0, then READ(0)-WRITE(1)-READ(1) is performed. On the other hand, if *v* is 1, then READ(1)-WRITE(0)-READ(0) is performed.

(REFRESH_A_ROW, *, *r*, *) refreshes the contents of every cell in row *r.*

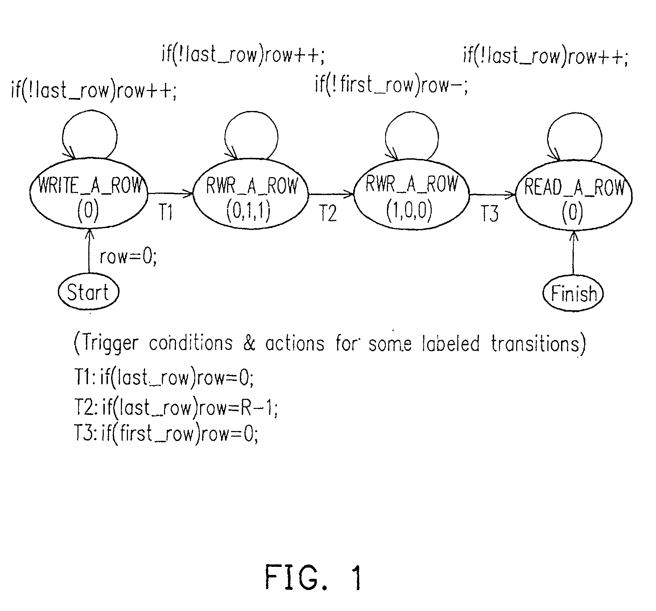

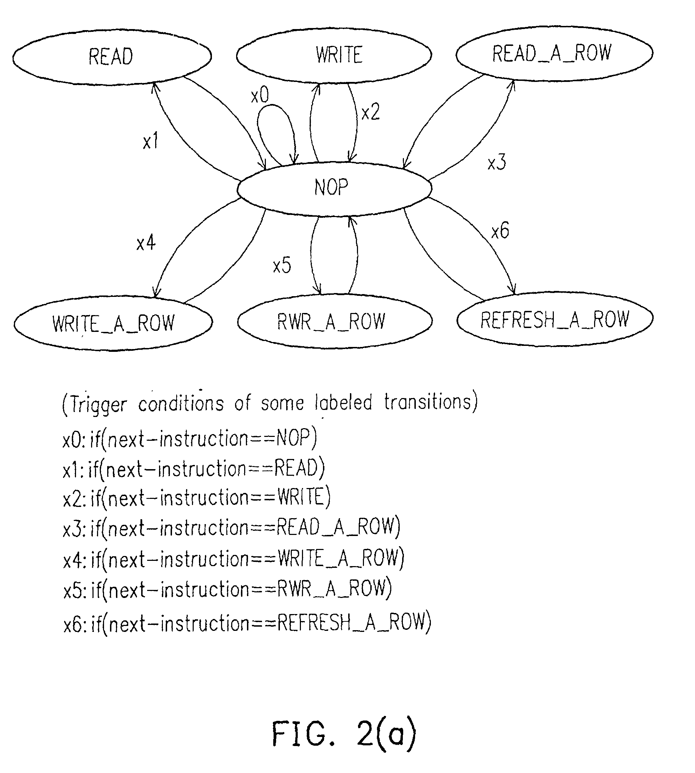

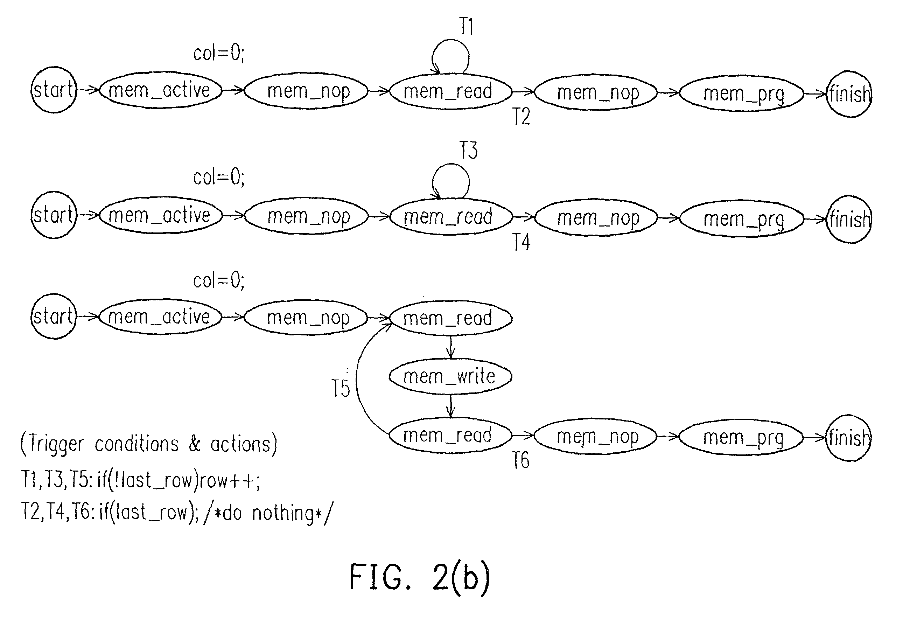

A detailed description of the march algorithm is given in this paragraph. Assume that the memory array under test has *R* rows and *C* columns. Fig. 1, Fig.2(a) and Fig. 2(b) respectively show the state transition graphs of the two finite machines for implementing the marching algorithm. Both machines operate along with an incrementer that keeps track of the row address and/or column address (represented by variables *row* and *col*). The first machine comprises four symbolic states excluding the *start* and *finish* states as shown in Fig. 1. Each transition may associate a trigger condition and an operation. The trigger condition is the condition that needs to be satisfied in order to exercise the associated transition, while the operation is the action to be taken with the transition.

For example, if the present state is the state labeled WRITE A_ROW(0) and the row address is the last (that is. *row*=*R*-1), then the machine will take the transition labeled T1 and the following actions:

Produce a macro-instruction (WRITE_A_ROW, 0, *row*, *)

Set the variable *row* to 0.

Go to the next state labeled RWR_A_ROW(0, 1, 1).

The second machine, as shown in Fig. 2(a) and Fig. 2(b), taking the macro-instructions generated by the first machine as input, is a hierarchical state machine with seven sub-machines. Each sub-machine is used to interpret one type of macro-instruction. For simplicity, only the three sub-machines needed for the march algorithm described above is shown (that is, READ_A_ROW, WRITE_A_ROW, and RWR_A_ROW) In a more sophisticated test algorithm of a DRAM, for example. the commonly used row disturb algorithm, may need all macro-instructions.

The BIST Circuit

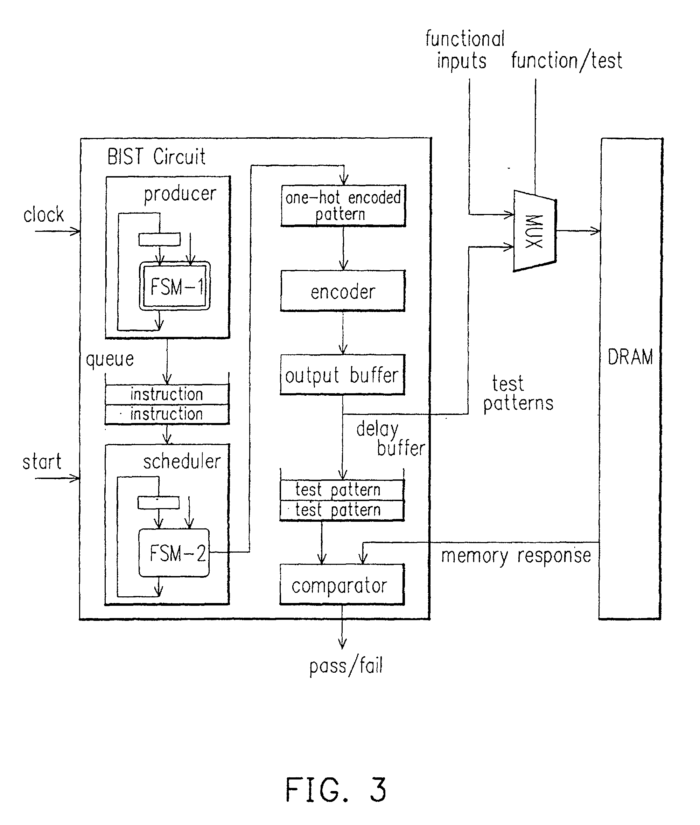

Fig. 3 shows a block diagram of a built-in self-test circuit for testing a memory according to a preferred embodiment of the invention. This built-in self-test circuit is particularly applicable for testing a memory requiring a complex test algorithm, for example, for testing a dynamic random access memory. The main objective of the BIST circuit is to translate a number of high-level abstract algorithms into a sequence of test patterns. In order to provide the capability of at-speed testing, the BIST circuitry needs to operate at least as fast as the memory device under test. However, as the complexity of the test algorithm grows, the single finite state machine may become too large, and thus too slow to produce a test pattern for every clock cycle when applied to high-speed memory devices. Therefore, a pipeline technique is employed and a high-speed BIST architecture comprising dual finite state machines is provided in the invention.
As shown in Fig. 3, the BIST circuit comprises a first finite state machine, namely, a producer, a queue, a second finite state machine, also called a scheduler, an encoder, an (BIST) output buffer (BOB), a delay buffer, and a comparator. A pipeline technique is employed to construct the BIST circuit. There are three stages in this pipeline design, that is, a macro-instruction generation via the producer in the first stage, a macro-instruction scheduling via the scheduler in the second stage, and a memory command encoding via the encoder in the third stage. Between the producer and the scheduler, a communicating protocol is established and will be described as follows.
While the producer receives a high-level test algorithm, the test algorithm is translated into a sequence of macro-instructions thereby. This is the first stage of a pipeline.
The second finite machine interprets each macro-instruction into a sequence of test patterns, in which memory command parts are one-hot encoded. This component, related to the interface with the memory device, forms the second stage of the pipeline.
The queue is preferably a first-in-first-out register, serving as a synchronization buffer connected between the first and the second finite machines. In general, the producer is capable of producing one macro-instruction every cycle. However, the scheduler can take multiple clock cycles to complete the processing of a macro-instruction. Therefore, the producer may have to be stalled from time to time in order to avoid overloading the scheduler with excessive macro-instructions. Therefore, a simple master-slave synchronization mechanism is used, wherein the scheduler is the master which controls the action of the producer and the synchrontzation queue through a signal named '*next*', When the signal '*next*' is low, the producer and the queue are frozen, that is, the value of every flip-flop of the queue remains unchanged regardless of the clocking. On the other hand, as the signal '*next*' is raised to high, the current macro-instruction produced by the producer is inserted to the queue at the specified clock edge. Meanwhile, the producer enters the next state to compute the next macro-instruction. In other words, when the signal '*next*' is asserted, the queue performs a shift-forward operation and latches in a new instruction generated by the producer at the same clock cycle. On the other hand, if the signal '*next*' is de-asserted, the queue performs no operation. Thus, the only operation associated with this queue is "*latch-and-shift-forward*".
The encoder is a piece of combinational logic that maps the encoding of each memory command in the test patterns output by the scheduler from one-hot to the one defined by the memory device. For example, if an input vector of the input test pattern is (00001, 0, 0, 0), where "00001" represents the one-hot code of a read memory command. Being processed by the encoder, this read memory command is encoded into a binary code of a read memory command defined by the memory device to be tested by the BIST circuit.
The BIST output buffer is a register that serves as a buffer between the BIST circuit and the memory device. This buffer eliminates the potential performance degradation of the memory device due to the introduction of the BIST circuit.
The delay buffer, again, is a first-in-first-out register file between the BIST output buffer and the comparator It is primarily for computing the expected responses of the read memory command. The number of clock cycle delays from BIST output buffer to the comparator corresponds to the CAS-latency defined by the memory device.
The comparator is a piece of combinational logic that compares the output responses of the memory device with the expected values provided by the delay buffer. For example, if a test pattern (*mem_read*, 1, 0, 0) is applied to the memory device and the CAS-latency is two, then two clock cycles later, the memory device is supposed to produce a '1' at the data output. Meanwhile, the same test pattern should arrive at the comparator through the delay buffer and the data part '1' of the test pattern (*mem_read*, 1, 0, 0), can be extracted as the expected value for the comparison.

The Speed-Up Technique

In addition to the high performance design techniques, such as one-hot encoding and retiming, a technique called protocol-based relaxation to boost the BIST circuit speed is further proposed. This technique is based on an observation that, among the three stages, the timing critical paths are mostly the producer. To relax the timing criticality, the producer is transformed into a multi-cycle path component (that is, a component produces one result for every two clock cycles or more). Since scheduler controls the action of the producer, this can be achieved by modifying the scheduler. The modification needs to be done in such a way that the signal '*next*' will not be raised to high for two consecutive clock cycles.

All the macro-instructions discussed earlier on take more than one clock cycle to execute NOP which originally corresponds to a single test pattern (*mem_nop*, *, *, *). In order to comply with the above protocol, the interpretation of this macro-instruction to two *mem_nop* memory patterns, that is,

$$NOP=(mem\_nop, *, *, *) \rightarrow (mem\_nop, *, *, *)$$

The increase in test time due to this modification is negligible, while the performance of speedup is significant.

From the above introduction, the method and the BIST circuit for testing a memory device such as a DRAM can thus be briefly summarized as follows. While a test algorithm is input to the producer, the test algorithm is translated into a sequence of macro-instructions. Being synchronized by a queue according to a communication protocol, each of the macro-instructions is interpreted into a sequence of one-hot encoded test patterns. Each of the one-hot encoded test patterns is then mapped to a code defined by the DRAM. Via the BIST delay buffer, the mapped codes are fed into the DRAM for performing a test. As shown in the figure, a multiplexer (MUX) is further installed between the BIST circuit and the DRAM. The test result, that is, the output response of the DRAM is then input to the comparator, so does an expected memory response. The comparator compares the output response of the DRAM with the expected memory response. While the test response of the memory appears the same as the expected response, the BIST circuit displays a "pass" information. On the contrary, if the test response of the memory is different from the expected response, the BIST circuit indicates a fail information.

Synthesis Results

The present invention has been implemented as a register transfer level (RTL) code. It is simulated with the functional model of the memory device under test to establish the confidence of its functional correctness. Synthesis tool, design compile, is used to convert this RTL code into a netlist and perform logic optimization using 0.25µm CMOS technology library. Static timing analysis tool, design time, shows theat the clock cycle time is under 2.21ns. The timing-driven feature of a place-and-rout tool, Apollo, is used generate the layout. Post-layout timing check shows no timing violation under above clock cycle time. Based on these results, we thus can conclude the proposed BIST architecture in the invention has great potential to run as fast as 450MHz.

**Claims**

**1.** A built-in self-test (BIST) circuit for a dynamic random access memory (DRAM), comprising:

a first finite machine, to translate an input test algorithm into a sequence of macro-instructions;
a second finite machine, to interpreting each of the macro-instructions into a sequence of one-hot encoded test patterns;
a first-in-first out register, to serve as a synchronization buffer between the first and the second finite machines;
an encoder, to encode one-hot codes of the test patterns into binary codes defined by the DRAM;
a BIST output buffer, to serve as a buffer for the binary codes which is then fed into the DRAM for performing a test;
a delay buffer, to delay an expected DRAM response according to the one-hot encoded test patterns; and
a comparator, to compare an output response of the DRAM with the expected DRAM response provided by the delay buffer, so as to determine whether the memory device functions correctly.

**2.** The interconnect structure according to claim 1, wherein the sequence of macro-instructions are defined according to a sequence of memory commands defined by the DRAM.

3. The built-in self-test circuit according to claim 1, further comprises a multiplexer between the built-in self-test circuit and the DRAM.

4. The built-in self-test circuit according to claim 1, wherein the delay buffer comprises a first-in-first-out register.

5. A method for testing a memory device using a built-in self-test circuit, the method comprising:

translating a test algorithm into a sequence of macro-instructions according to a plurality of memory commands defined by the memory device;
translating each of the macro-instructions into a sequence of one-hot encoded test patterns which comprises data, address, and commands;
encoding a plurality of one-hot codes of the test patterns into binary codes defined by the memory device to perform a test on the memory device;
delaying an expected memory response corresponding to a CAS latency defined by the memory device; and
comparing the expected memory response with an output response of the memory device after being tested to determine whether the memory device functions normally.

6. The method according to claim 5, wherein a producer is used to generate the sequence of the macro-instructions.

7. The method according to claim 6, wherein a scheduler is used to translate each of the macro-instructions into the sequence of test patterns.

8. The method according to claim 7, wherein a queue is implemented to communicate the producer and the scheduler using a synchronization master-slave mechanism.

9. The method according to claim 8, wherein the scheduler performs as the master to control the queue and the producer as a slave.

10. The method according to claim 6, wherein the producer, the scheduler, and an encoder which performs the encoding steps construct a three-stage pipeline.

11. The method according to claim 5, wherein the memory device comprises a dynamic random access memory.

12. The method according to claim 5, wherein the memory device fails if the expected memory response is the same as the output response of the memory device after being tested, while the memory device passes if the expected memory response differs from the output response of the memory device.

**Patentansprüche**

1. Integrierter Selbsttest-Schaltkreis (BIST) für einen dynamischen Direktzugriffsspeicher (DRAM), welcher aufweist:

einen ersten endlichen Automaten zum Übersetzen eines Eingabe-Test-Algorithmus in eine Sequenz von Makro-Anweisungen;
einen zweiten endlichen Automaten, zum Interpretieren jeder der Makro-Anweisungen in eine Sequenz von one-hot kodierten Testmustern;
ein first-in-first-out Register, das als Synchronisations-Puffer zwischen dem ersten endlichen Automaten und dem zweiten endlichen Automaten dient; einen Kodierer, zum Kodieren von one-hot Kodes der Testmuster in Binärkodes, welche mittels des DRAMs definiert sind;
einen BIST Ausgangspuffer, der als Puffer für die Binärkodes dient, welche dann zum Ausführen eines Tests in den DRAM eingegeben werden;
einen Verzögerungspuffer zum Verzögern einer erwarteten DRAM-Antwort gemäß den one-hot kodierten Testmustern; und
einen Komparator zum Vergleichen einer Ausgangsantwort des DRAMs mit der erwarteten Antwort des DRAMs, welche von dem Verzögerungspuffer bereitgestellt wird, um so zu entscheiden, ob die Speichereinheit korrekt funktioniert.

2. Verknüpfungsstruktur gemäß Anspruch 1, wobei die Sequenz an Makro-Anweisungen gemäß einer Sequenz von Speicherbefehlen definiert ist, welche mittels des DRAMs definiert ist.

3. Integrierter Selbsttest-Schaltkreis gemäß Anspruch 1, welcher weiterhin einen Multiplexer zwischen dem integrierten Selbsttest-Schaltkreis und dem DRAM aufweist.

4. Integrierter Selbsttest-Schaltkreis gemäß Anspruch 1, wobei der Verzögerungspuffer ein first-in-first-out Register aufweist.

5. Verfahren zum Testen einer Speichereinrichtung, unter Verwendung eines integrierten Selbsttest-Schaltkreises, wobei das Verfahren aufweist:

   Übersetzen eines Test-Algorithmus in eine Sequenz von Makro-Anweisungen gemäß einer Mehrzahl von Speicherbefehlen, welche mittels der Speichereinrichtung definiert werden;
   Übersetzen jeder der Makro-Anweisungen in eine Sequenz von one-hot kodierten Testmuster, welche Daten, eine Adresse und Befehle aufweisen;
   Kodieren einer Mehrzahl von one-hot Kodes der Testmuster in Binärkodes, welche mittels der Speichereinrichtung definiert werden, um auf der Speichereinrichtung einen Test durchzuführen;
   Verzögern einer erwarteten Speicherantwort gemäß einer mittels der Speichereinrichtung definierten CAS-Latenzzeit; und
   Vergleichen der erwarteten Speicher-Antwort mit einer Ausgabe-Antwort der Speichereinrichtung, nachdem sie, um zu entscheiden, ob die Speichereinrichtung normal funktioniert, getestet wurde.

6. Verfahren gemäß Anspruch 5, wobei ein Generator verwendet wird, um die Sequenz von Makro-Anweisungen zu erzeugen.

7. Verfahren gemäß Anspruch 6, wobei ein Scheduler verwendet wird, um jede der Makro-Anweisungen in die Sequenz von Testmustern zu übersetzen.

8. Verfahren gemäß Anspruch 7, wobei eine Warteschlange implementiert ist, um den Generator und den Scheduler in Verbindung zu bringen, wobei ein Synchronisations-Master-Slave Mechanismus verwendet wird.

9. Verfahren gemäß Anspruch 8, wobei der Scheduler als Master zum Steuern der Warteschlange und der Generator als Slave funktionieren.

10. Verfahren gemäß Anspruch 6, wobei der Generator, der Scheduler und ein Koder, welcher die Kodierschritte durchführt, eine dreistufige Pipeline bilden.

11. Verfahren gemäß Anspruch 5, wobei die Speichereinrichtung einen dynamischen Direktzugriffsspeicher aufweist.

12. Verfahren gemäß Anspruch 5, wobei die Speichereinrichtung versagt, wenn die erwartete Speicher-Antwort die gleiche ist wie die Ausgangs-Antwort der Speichereinrichtung, nachdem die Speichereinrichtung getestet wurde, während die Speichereinrichtung besteht, wenn die erwartete Speicher-Antwort von der Ausgangs-Antwort der Speichereinrichtung abweicht.

**Revendications**

1. Un circuit d'auto-test incorporé (BIST) pour une mémoire vive dynamique (DRAM) comprenant :

   un premier automate à états finis, pour traduire un algorithme de test d'entrée en une séquence de macro-instructions;
   un second automate à états finis, pour interpréter chacune des macro-instructions de façon à donner une séquence de configurations de test codées en mode appelé "one-hot";
   un registre premier entré - premier sorti, pour remplir la fonction d'un tampon de synchronisation entre les premier et second automates à états finis;
   un codeur pour coder des codes one-hot des configurations de test en codes binaires définis par la mémoire DRAM;
   un tampon de sortie de BIST pour remplir la fonction d'un tampon pour les codes binaires dont le contenu est ensuite fourni à la mémoire DRAM pour effectuer un test;

un tampon de retard pour retarder une réponse de mémoire DRAM attendue, conformément aux configurations de test codées en one-hot; et

un comparateur pour comparer une réponse de sortie de la mémoire DRAM avec la réponse de mémoire DRAM attendue qui est fournie par le tampon de retard, de façon à déterminer si le dispositif de mémoire fonctionne correctement.

2. La structure d'interconnexion de la revendication 1, dans laquelle la séquence de macro-instructions est définie conformément à une séquence d'ordres de mémoire définis par la mémoire DRAM.

3. Le circuit d'auto-test incorporé selon la revendication 1, comprenant en outre un multiplexeur entre le circuit d'auto-test incorporé et la mémoire DRAM.

4. Le circuit d'auto-test incorporé selon la revendication 1, dans lequel le tampon de retard comprend un registre premier entré - premier sorti.

5. Un procédé pour tester un dispositif de mémoire utilisant un circuit d'auto-test incorporé, le procédé comprenant les étapes suivantes:

on traduit un algorithme de test en une séquence de macro-instructions conformément à une multiplicité d'ordres de mémoire définis par le dispositif de mémoire;

on traduit chacune des macro-instructions en une séquence de configurations de test codées en mode one-hot qui comprennent des données, des adresses et des ordres;

on code une multiplicité de codes one-hot des configurations de test en codes binaires définis par le dispositif de mémoire, pour effectuer un test sur le dispositif de mémoire;

on retarde une réponse de mémoire attendue correspondant à une latence de CAS définie par le dispositif de mémoire; et

on compare la réponse de mémoire attendue avec une réponse de sortie du dispositif de mémoire après que celui-ci a été testé, pour déterminer si le dispositif de mémoire fonctionne normalement.

6. Le procédé selon la revendication 5, dans lequel on utilise un producteur pour générer la séquence des macro-instructions.

7. Le procédé selon la revendication 6, dans lequel on utilise un séquenceur pour traduire chacune des macro-instructions de façon à former la séquence de configurations de test.

8. Le procédé selon la revendication 7, dans lequel une file d'attente est réalisée pour faire communiquer le producteur et le séquenceur en utilisant un mécanisme de synchronisation maître-esclave.

9. Le procédé selon la revendication 8, dans lequel le séquenceur fonctionne comme le maître pour commander la file d'attente, et le producteur fonctionne comme un esclave.

10. Le procédé selon la revendication 6, dans lequel le producteur, le séquenceur et un codeur qui accomplit les étapes de codage forment un pipeline à trois étages.

11. Le procédé selon la revendication 5, dans lequel le dispositif de mémoire comprend une mémoire vive dynamique.

12. Le procédé selon la revendication 5, dans lequel le dispositif de mémoire est considéré comme défectueux si la réponse de mémoire attendue est la même que la réponse de sortie du dispositif de mémoire après qu'il a été testé, tandis que le dispositif de mémoire est considéré comme bon si la réponse de mémoire attendue diffère de la réponse de sortie du dispositif de mémoire.

if(!last_row)row++;

if(!last_row)row++;

if(!last_row)row++;

if(!first_row)row−;

FIG. 1

(Trigger conditions & actions for some labeled transitions)

T1: if(last_row)row=0;

T2: if(last_row)row=R−1;

T3: if(first_row)row=0;

(Trigger conditions of some labeled transitions)

x0: if(next-instruction==NOP)

x1: if(next-instruction==READ)

x2: if(next-instruction==WRITE)

x3: if(next-instruction==READ_A_ROW)

x4: if(next-instruction==WRITE_A_ROW)

x5: if(next-instruction==RWR_A_ROW)

x6: if(next-instruction==REFRESH_A_ROW)

FIG. 2(a)

FIG. 2(b)

(Trigger conditions & actions)

T1,T3,T5: if(!last_row)row++;

T2,T4,T6: if(last_row); /*do nothing*/

FIG. 3

instruction generator

FSM-1

instructions

Queue

'next'

scheduler

FSM-2

memory commands

FIG. 4